# EUROPEAN PATENT APPLICATION

(11) **EP 2 947 685 A1**
(43) Date of publication of application: **25.11.2015**
(21) Application number: 14861114.8
(22) Date of filing: 03.04.2014
(51) Int. Cl.: H01L 21/66

(54) **SEMICONDUCTOR TEST PAD HAVING STACKED METAL FOILS AND MANUFACTURING METHOD THEREOF**

(30) Priority: 22.11.2013 KR 20130142617; 26.03.2014 KR 20140035410
(71) Applicant: Silicone Valley Co., Ltd, Gim Cheon-si, Gyeongsangbuk-do 740-180 (KR)
(72) Inventor: YOUN, Kyoungseob, Gyeongsangbuk-do 730-799 (KR)
(74) Representative: Carvajal y Urquijo, Isabel
(86) International application number: PCT/KR2014/002861
(87) International publication number: WO 2015/076465

(57) **Abstract**

The present invention relates to a semiconductor test pad used in a semiconductor test, and more specifically, to a semiconductor test pad with stacked metal sheets, which is manufactured by preparing a first sheet using a thin metal plate, etching and stacking and then vertically cutting the first sheet, and a method for manufacturing the same. The semiconductor test pad includes first layers, each of which includes an insulator rectangular in cross section and having a predetermined length along a Y-axis direction, and second layers, each of which includes a plurality of rectangular conductors passing, in a Z-axis direction and at predetermined intervals, through insulators each rectangular in cross section and having the same height along the Z-axis direction as the first layer and the same length along the Y-axis direction, wherein the first layers and the second layers are alternately stacked along the X-axis direction, thus allowing the semiconductor test pad to overall look like a rectangular pad, and wherein first layers are positioned at both end portions along the X-axis.

## Description

### TECHNICAL FIELD

The present invention relates to a semiconductor test pad used in a semiconductor test, and more specifically, to a semiconductor test pad with stacked metal sheets, which is manufactured by preparing a first sheet using a thin metal plate, etching and stacking and then vertically cutting the first sheet, and a method for manufacturing the same.

### DISCUSSION OF RELATED ART

In general, whether there are errors in manufacturing semiconductors is checked by testing electrical performance of in manufacturing semiconductors, and the test is performed while semiconductor test sockets formed to be able to electrically contact the terminals of semiconductor devices are interposed between the semiconductor devices and test circuit boards. Semiconductor test sockets are used in the burn-in test process among the processes for manufacturing semiconductor devices, as well as in testing the semiconductor devices.

The development of semiconductor device integration technology and the trend of miniaturizing semiconductor devices led to the terminals, i.e., leads, of semiconductor devices being reduced in size and intervals. Required is thus a method for forming fine intervals between conductive patterns of test sockets. There are limits to testing semiconductor devices, which are being integrated, using conventional pogo-type semiconductor test sockets.

Moreover, as terminals for electrical connections of semiconductor test sockets or probes directly contact semiconductors that have been made fine and thin, the semiconductors may be physically damaged. The minimum pitch between electrodes currently available is 250 µm, and there is a need for further reducing the pitch.

In a technique proposed to address the above issues and being widely used, a punctuated pattern is formed on the silicone body made of an elastic silicone substance in the vertical direction, and is then filled with a conductive powder to thus form a conductive pattern.

However, the method of filling with the conductive powder may cause the conductive powder to be escaped due to the poor durability of semiconductor test pad, thus lowering the number of times that it can be repeatedly used.

In another proposed method to implement fine pitches in the semiconductor test pad, conductive sheets and insulating sheets, after alternately stacked, are vertically cut to a fine thickness of a few tens of micrometers, and are then stacked and vertical-cut. However, if vertically cut to the fine thickness, the conductors may be escaped out of place due to the small thickness, and it is difficult to cut to the fine thickness.

### SUMMARY

An object of the present invention made to solve the above problems is to provide a semiconductor test pad with stacked metal sheets, which has increased durability and uses a conductive powder.

Another object of the present invention is to provide a semiconductor test pad with metal sheets having a fine pitch of a few tens of micrometers between conductors.

Still another object of the present invention is to provide a method for manufacturing a semiconductor test pad with stacked metal sheets in a simplified process as compared with the manufacturing methods using conventional stacking methods.

To achieve the above objects, according to a first embodiment of the present invention, a method for manufacturing a semiconductor test pad with stacked metal sheets includes a sheet preparing step of preparing a first sheet by coating a conductive thin metal plate with an insulating first resin, an etching step of preparing a second sheet by etching the first sheet of the thin metal plate to have a plurality of lines so that conductors respectively on the lines are spaced apart from each other at predetermined distances, a stacking step of preparing a stack by stacking a plurality of second sheets, and a cutting step of vertically cutting the stack to a predetermined thickness.

Further, the first resin includes at least any one of silicone, urethane, PE, PP, PT, PET, PEN, PI, and rubber.

Further, the method further comprising, after the etching step, a coating step of coating a second resin on an upper portion of the second sheet formed with the conductors on the lines so that the second resin is formed as an insulator.

Further, the second resin includes at least any one of silicone, urethane, PE, PP, PT, and rubber.

Further, before coating the first resin or the second resin, a primer is applied on a surface where to be coated to increase the adhesivity of a resin to be coated.

The method further comprises, after the cutting step, a plating step of performing electroless plating on a surface of the semiconductor test pad to prevent the conductors from being oxidized.

Further, the thin metal plate includes at least any one of Cu, Au, Ag, Pt, Fe, Al, Ni, Mg, Pb, Zn, Sn, Co, Cr, Mn, and C.

According to a second embodiment of the present invention, a semiconductor test pad with stacked metal sheets and a method for manufacturing the same includes a sheet manufacturing step S1 of preparing a first sheet by attaching a conductive thin metal plate onto a surface of an insulating film, an etching step S2 of manufacturing a second sheet by etching the first sheet of the thin metal plate to have a plurality of lines so that conductors respectively on the lines are spaced apart from each other at a predetermined distance, a stacking step S3 of manufacturing a stack by stacking a plurality of second sheets, and a cutting step S4 of vertically cutting the stack to a predetermined thickness.

Further, the film includes at least any one of silicone, urethane, PI, PET, PEN, PE, PP, PT, and rubber.

Further, in the stacking step, an adhesive is applied onto an upper portion of the second sheet where the conductors on the lines are formed, and the plurality of second sheets are stacked using an adhesive layer formed of the adhesive.

Further, the adhesive layer includes at least any one of silicone, urethane, PI, PET, PEN, PE, PP, PT, and rubber.

According to the present invention, a semiconductor test pad with stacked metal sheets includes first layers, each of which includes an insulator rectangular in cross section and having a predetermined length along a Y-axis direction, and second layers, each of which includes a plurality of rectangular conductors passing, in a Z-axis direction and at predetermined intervals, through insulators each rectangular in cross section and having the same height along the Z-axis direction as the first layer and the same length along the Y-axis direction, wherein the first layers and the second layers are alternately stacked along the X-axis direction, thus allowing the semiconductor test pad to overall look like a rectangular pad, and wherein first layers are positioned at both ends along the X-axis.

Further, the semiconductor test pad further comprises a plating layer on each of an upper surface and a lower surface of the conductors.

As described above, in the semiconductor test pad with stacked metal sheets according to the present invention, the conductors have high durability using the deposited metal plate.

Further, the semiconductor test pad with stacked metal sheets according to the present invention may have fine pitches at which the distances between the conductors are a few tens of micrometers and thus may be applicable to more integrated semiconductors.

Further, the method for manufacturing a semiconductor test pad with stacked metal sheets according to the present invention enables manufacture in a simplified way as compared with conventional deposition-based manufacturing methods, thus leading to enhanced productivity and quality.

### BRIEF DESCRIPTION OF THE DRAWINGS

Fig. 1 is a flowchart illustrating a method for manufacturing a semiconductor test pad with stacked metal sheets according to the present invention.
Fig. 2 is a perspective view illustrating a primary primer applying step of a method for manufacturing a semiconductor test pad with stacked metal sheets according to the present invention.
Fig. 3 is a perspective view illustrating a sheet preparing step of a method for manufacturing a semiconductor test pad with stacked metal sheets according to the present invention.
Fig. 4 is a perspective view illustrating an etching step of a method for manufacturing a semiconductor test pad with stacked metal sheets according to the present invention.
Fig. 5 is a perspective view illustrating a coating step of a method for manufacturing a semiconductor test pad with stacked metal sheets according to the present invention.
Fig. 6 is a view illustrating applying an adhesive in a stacking step of a method for manufacturing a semiconductor test pad with stacked metal sheets according to the present invention.
Fig. 7 is a perspective view illustrating a stacking step of a method for manufacturing a semiconductor test pad with stacked metal sheets according to the present invention.
Fig. 8 is a perspective view illustrating a cutting step of a method for manufacturing a semiconductor test pad with stacked metal sheets according to the present invention. 4
Fig. 9 is a perspective view illustrating a semiconductor test pad with stacked metal sheets according to the present invention.

**[DESCRIPTION OF ELEMENTS]**

| | | | |
|---|---|---|---|
| 1: | Thin metal plate | 2: | First resin |
| 3: | Second resin | 4: | Film |
| 5: | Semiconductor test pad | 6: | Adhesive layer |
| 10: | Adhesive | 11: | Conductor |
| 21: | Insulator | 30: | Press roller |
| 40: | Primer | 50: | Laser |
| 60: | First sheet | 61: | Second sheet |
| 62: | Stack | | |

### DETAILED DESCRIPTION OF EXEMPLARY EMBODIMENTS

Various changes may be made to the present invention, and the present invention may come with a diversity of embodiments. Some embodiments of the present invention are shown and described in connection with the drawings. However, it should be appreciated that the present invention is not limited to the embodiments, and all changes and/or equivalents or replacements thereto also belong to the scope of the present invention. Similar reference denotations are used to refer to similar elements throughout the drawings.

The terms "first" and "second" may be used to describe various components, but the components should not be limited by the terms. The terms are used only to distinguish one component from another. For example, a first component may be denoted a second component, and vice versa without departing from the scope of the present disclosure. The term "and/or" may denote a combination(s) of a plurality of related items as listed or any of the items.

When a component is "connected to" or "coupled to" another component, the component may be directly connected or coupled to the other component, or other component(s) may intervene therebetween. In contrast, when a component is "directly connected to" or "directly coupled to" another component, no other intervening components may intervene therebetween.

The terms as used herein are provided merely to describe some embodiments thereof, but not to limit the present invention. It is to be understood that the singular forms "a," "an," and "the" include plural references unless the context clearly dictates otherwise. It will be further understood that the terms "comprise" and/or "have," when used in this specification, specify the presence of stated features, integers, steps, operations, elements, and/or components, but do not preclude the presence or addition of one or more other features, integers, steps, operations, elements, components, and/or groups thereof.

Hereinafter, embodiments of the present invention are described in detail with reference to the accompanying drawings. Hereinafter, the same reference denotations are used to refer to the same elements throughout the drawings, and no repetitive description of the same element is given.

Hereinafter, preferred embodiments of the present invention are described in detail with reference to the accompanying drawings.

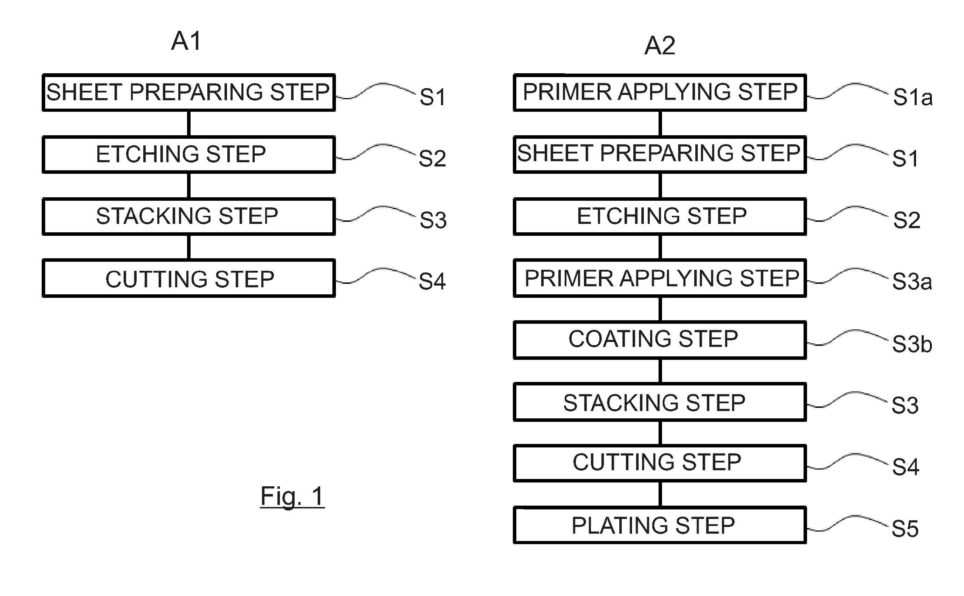

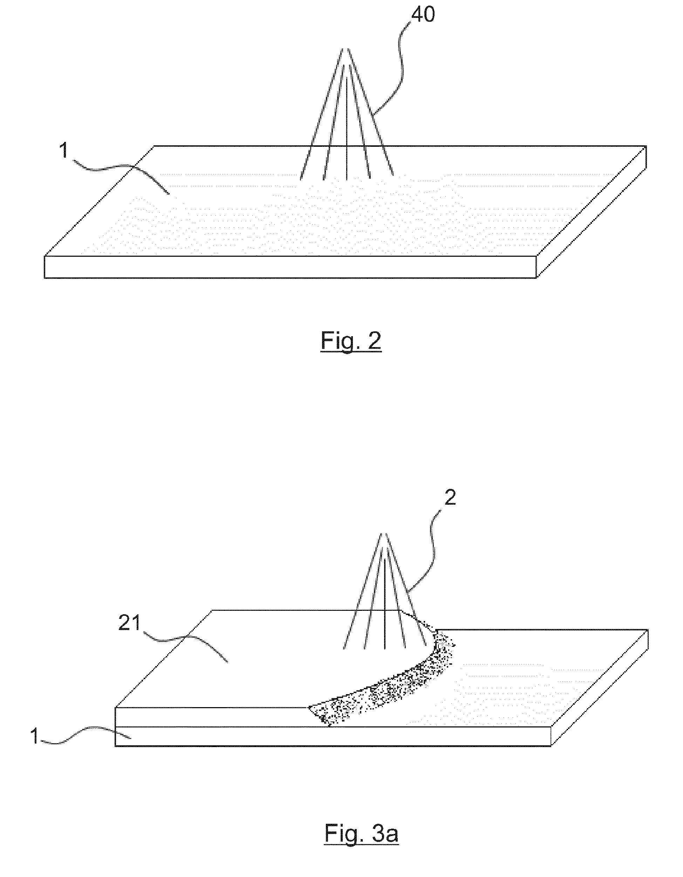

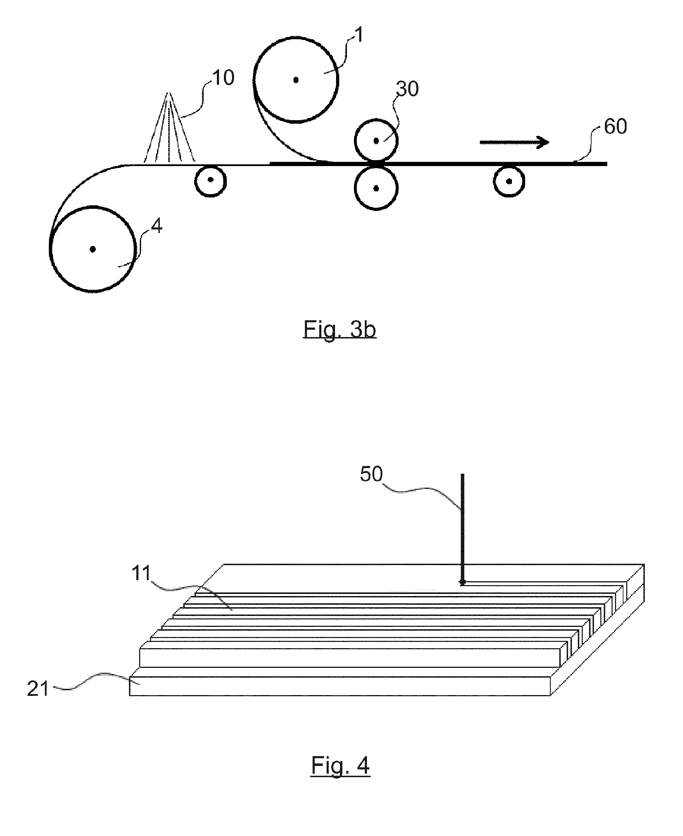

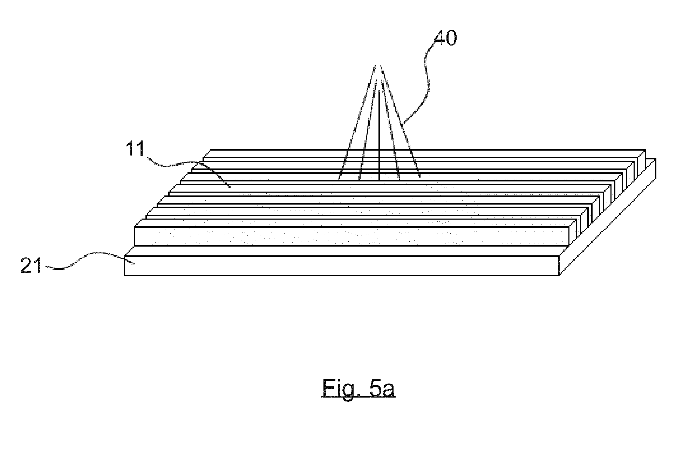

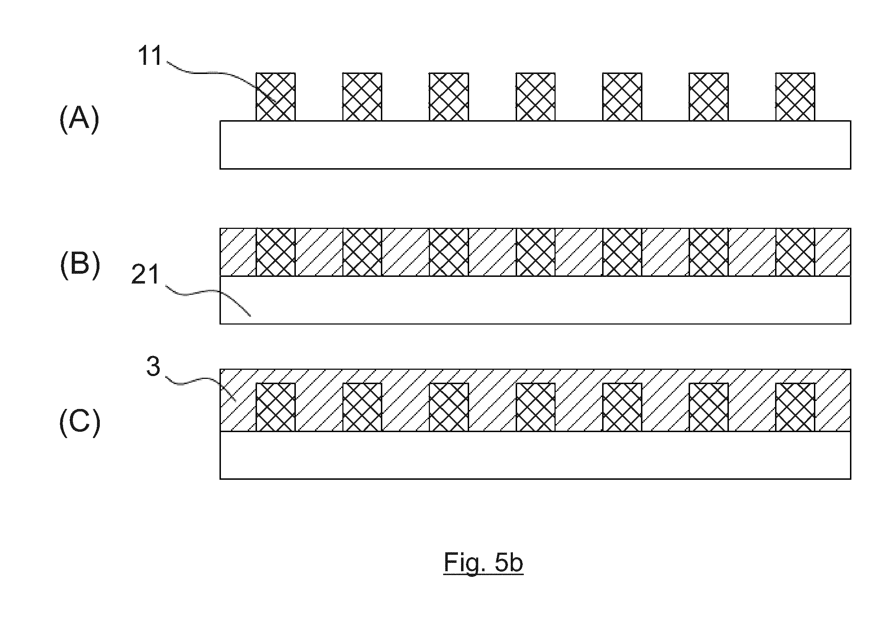

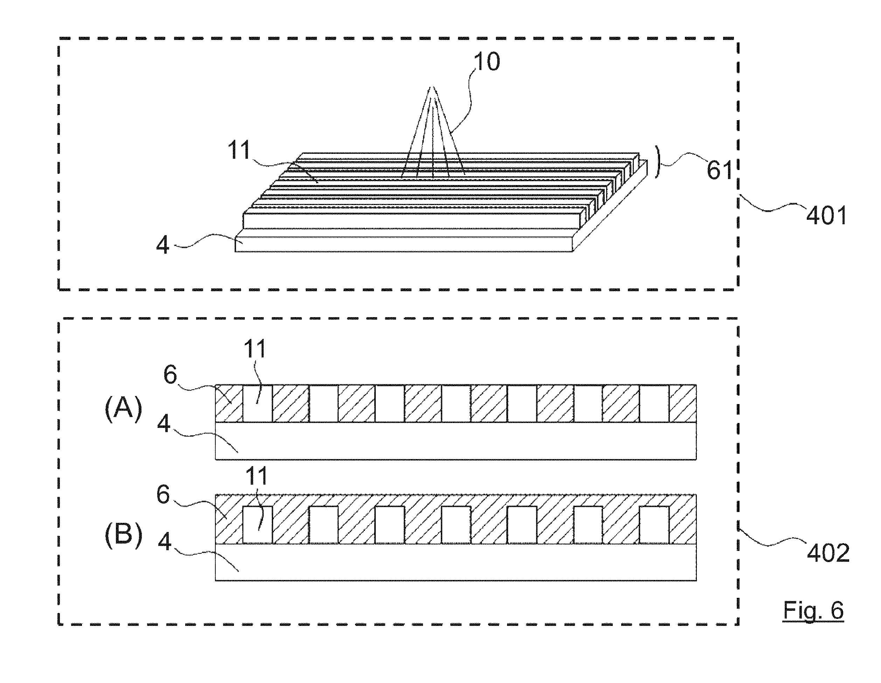

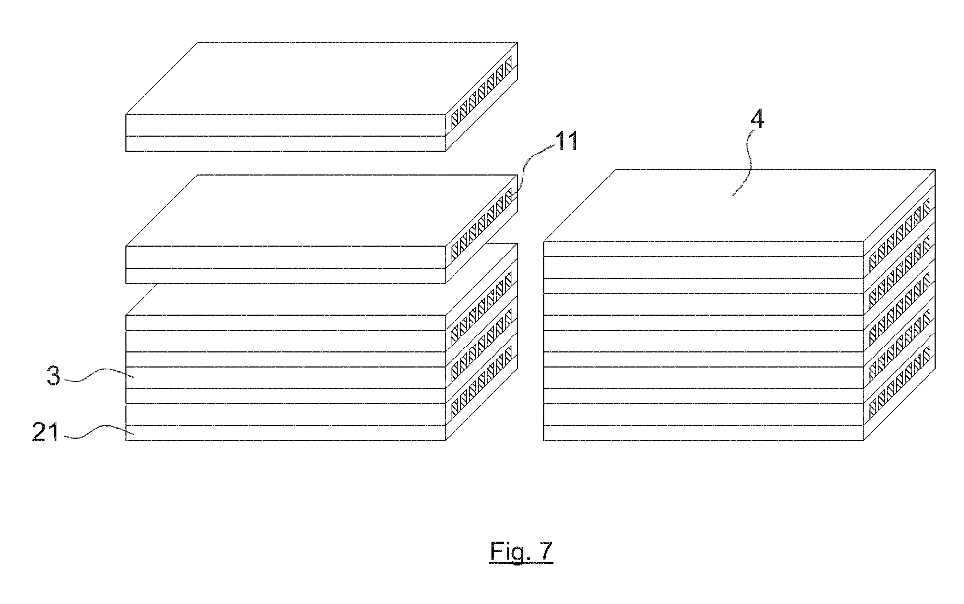

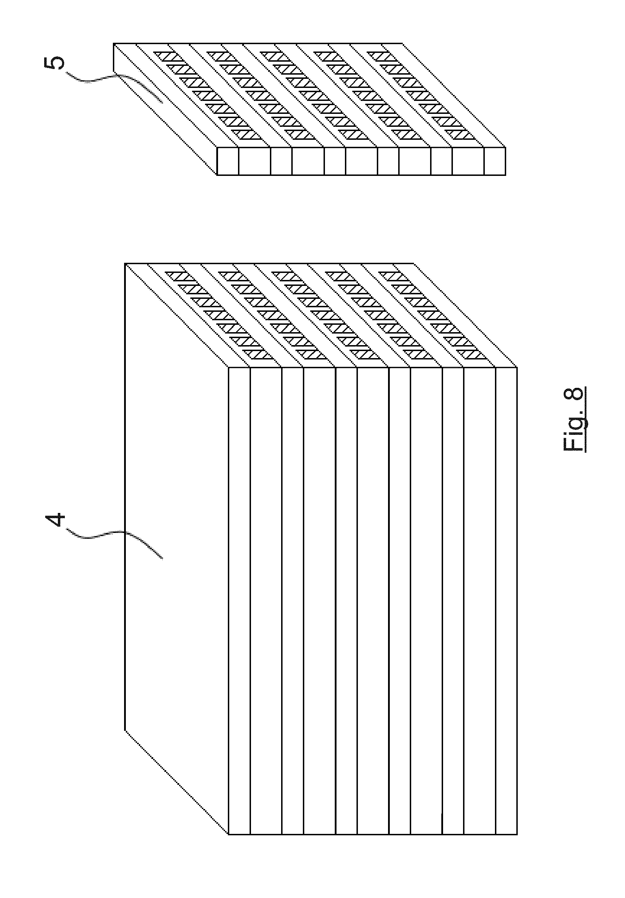

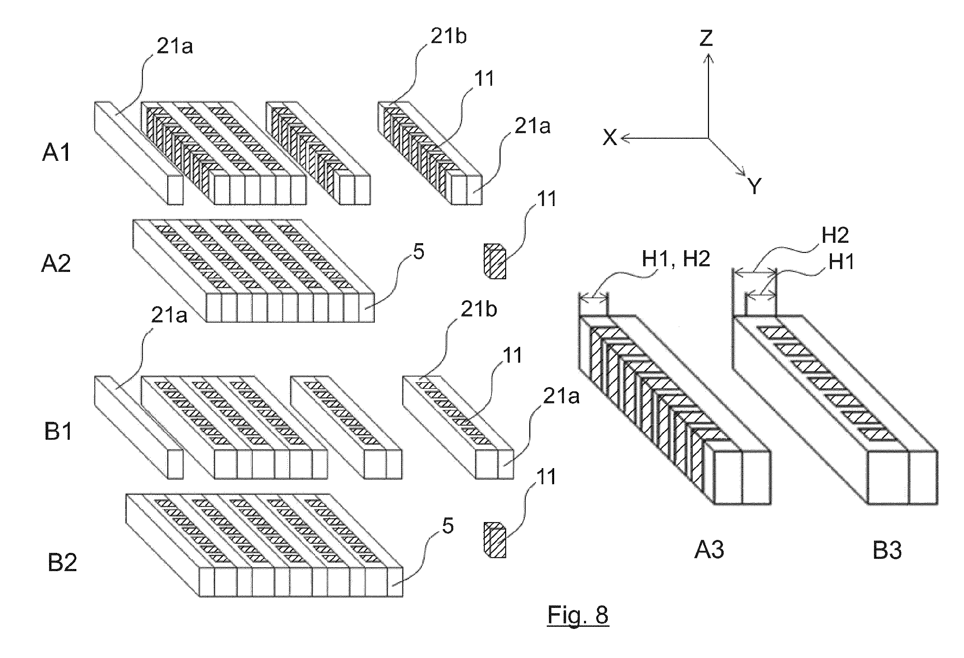

Fig. 1 is a flowchart illustrating a method for manufacturing a semiconductor test pad with stacked metal sheets according to the present invention. Fig. 2 is a perspective view illustrating a primary primer applying step of a method for manufacturing a semiconductor test pad with stacked metal sheets according to the present invention. Fig. 3 is a perspective view illustrating a sheet preparing step of a method for manufacturing a semiconductor test pad with stacked metal sheets according to the present invention. Fig. 4 is a perspective view illustrating an etching step of a method for manufacturing a semiconductor test pad with stacked metal sheets according to the present invention. Fig. 5 is a perspective view illustrating a coating step of a method for manufacturing a semiconductor test pad with stacked metal sheets according to the present invention. Fig. 6 is a view illustrating applying an adhesive in a stacking step of a method for manufacturing a semiconductor test pad with stacked metal sheets according to the present invention. Fig. 7 is a perspective view illustrating a stacking step of a method for manufacturing a semiconductor test pad with stacked metal sheets according to the present invention. Fig. 8 is a perspective view illustrating a cutting step of a method for manufacturing a semiconductor test pad with stacked metal sheets according to the present invention. Fig. 9 is a perspective view illustrating a semiconductor test pad with stacked metal sheets according to the present invention.

As shown in Fig. 1, a method for manufacturing a semiconductor test pad with stacked metal sheets, according to the present invention, includes a sheet preparing step S1, an etching step S2, a stacking step S3, and a cutting step S4, as denoted in A1.

Specifically, according to a first embodiment of the present invention, a method for manufacturing a semiconductor test pad with stacked metal sheets includes a sheet preparing step S1 of preparing a first sheet by coating a conductive thin metal plate 1 with an insulating first resin 2, an etching step S2 of preparing a second sheet by etching the first sheet of the thin metal plate 1 to have a plurality of lines so that conductors 11 respectively on the lines are spaced apart from each other at predetermined distances, a stacking step S3 of preparing a stack 62 by stacking a plurality of second sheets, and a cutting step S4 of vertically cutting the stack 62 to a predetermined thickness.

According to a second embodiment of the present invention, a method for manufacturing a semiconductor test pad with stacked metal sheets includes a sheet preparing step S1 of preparing a first sheet by attaching a conductive thin metal plate onto an insulating film, an etching step S2 of preparing a second sheet by etching the first sheet of the thin metal plate to have a plurality of lines so that conductors respectively on the lines are spaced apart from each other at a predetermined distance, a stacking step S3 of preparing a stack by stacking a plurality of second sheets, and a cutting step S4 of vertically cutting the stack to a predetermined thickness.

In another manufacturing method, primer applying steps S1a and S3a, a coating step S3b, and a plating step S5, as marked with A2, may be further provided. Any one only or two or more of the primer applying steps S1a and S3a, the coating step S3b, and the plating step S5 marked with A2 may be further included.

Although the primer applying step S1a and S3a have been denoted with the same term ("primer applying step") for convenience, steps S1a and S3a are performed at different times and thus may be denoted a first primer applying step S1a and a second primer applying step S3a.

Of the method for manufacturing a semiconductor test pad with stacked metal sheets according to the present invention, as shown in Fig. 2, the first primer applying step S1a is the step of applying a primer 40 onto a surface of the thin metal plate 1 to increase the adhesivity of the surface of the thin metal plate 1 and is a prior task for coating a resin or attaching an insulating film.

According to a preferred embodiment, the primer may be applied by any one of coating, paining, and spraying, and it is preferable to apply the primer to form a thickness of 1 µm to 2 µm.

In some cases, the method or amount of the application may vary depending on the material of the thin metal plate and the temperature or moisture at which the process is performed, or the first primer applying step S1a may be omitted.

Fig. 3(a) is a perspective view illustrating a sheet preparing step S1 of preparing a sheet by applying a first resin of a method for manufacturing a semiconductor test pad with stacked metal sheets according to a first embodiment of the present invention. In the sheet preparing step, a first resin 2 is applied to a surface of the thin metal plate 1 or thin metal plate 1 applied with the primer 40 through the first primer applying step S1a. The first resin 2 may be applied by any one of coating, painting, and spraying.

Further, the first resin 2 may include any one of silicone, urethane, PP, PE, PT, and rubber. A plurality of nozzles may be used to spray quickly and in a broader range.

Further, if the firs resin 2 is applied and coated on the surface of the thin metal plate 1, a first resin layer is formed on the surface of the thin metal plate 1, thus completing the preparation of the first sheet.

Further, the first resin layer (hereinafter, an insulator 21) plays a role as one insulator through the resin's characteristic of having insulating properties.

In a preferred embodiment, the insulator 21 is preferably coated to a thickness of 5 µm to 30 µm to provide high quality, but as necessary, the amount of the first resin 2 applied may be adjusted to have a thickness of 1 µm to 500 µm.

Further, in another embodiment, as the method of forming the insulator 21 on the thin metal plate 1 other than coating, a resin-based sheet may be attached to the thin metal plate 1 using an adhesive to prepare the first sheet, or a resin may be deposited and attached on a surface of the thin metal plate 1 through a depositing method such as PVD (Physical Vapor Deposition) or CVD (Chemical Vapor Deposition).

Fig. 3(b) is a perspective view illustrating a sheet preparing step S1 of attaching a film 4 using an adhesive 10 of a method for manufacturing a semiconductor test pad with stacked metal sheets according to a second embodiment of the present invention. In the sheet preparing step S1, the adhesive 10 or primer (hereinafter, "adhesive") is sprayed on a surface of a film 4, and the thin metal plate 1 is attached onto the surface of the film 4 through the adhesive.

According to a preferred embodiment, the adhesive 10 may be applied by any one of coating, paining, and spraying, and it is preferable to apply the primer to form a thickness of 1 µm to 50 µm.

Further, as the adhesive, one that, as cured, exhibits insulating properties should be selected, and for more insulation, the adhesive may further include any one of silicone, urethane, PI, PET, PEN, PE, PP, PT, and rubber, or any one of silicone, urethane, PI, PET, PEN, PE, PP, PT, and rubber may be applied in liquid phase for the purpose of an adhesive.

Further, as the film 4, one containing any one of silicone, urethane, PI, PET, PEN, PE, PP, PT, and rubber may be used, and as the thin metal plate 1, one containing at least one of Cu, Au, Ag, Pt, Fe, Al, Ni, Mg, Pb, Zn, Sn, Co, Cr, Mn, and C may be used.

The film 4 and the thin metal plate 1 is prepared into a first sheet 60 through the adhesive. The first sheet 60 may be pressurized on its top and bottom surface by a press roller 30 or press (not shown) to increase adhesivity between the film 4 and the thin metal plate 1 or to adjust the thickness of the first sheet 60.

In a preferred embodiment, the film 4 preferably has a thickness of 1 µm to 100 µm to obtain smaller inter-conductor distance, but as necessary (according to uses and distance of the terminal to be tested), the film 4 may be 1 µm to 5000 µm thick.

Further, the thin metal plate 1 preferably has a thickness of 1 µm to 100 µm to obtain finer conductors, but as necessary (according to uses and thickness of the terminal to be tested), the thin metal plate 1 may be 1 µm to 5000 µm thick.

Of the method for manufacturing a semiconductor test pad with stacked metal sheets according to the present invention, as shown in Fig. 4, the etching step S2 is to overturn the first sheet and etch the thin metal plate 1 into a second sheet. Specifically, the thin metal plate 1, which is positioned on a surface (hereinafter, "upper part") of the first sheet overturned upside down, is etched into a plurality of line-shaped conductors 11 (hereinafter, simply "conductors 11") that are spaced apart from each other at a predetermined interval.

In a preferred embodiment, the thin metal plate 1 is preferably etched so that the conductors 11 are spaced apart from each other at a distance of 1 µm to 50 µm that is the same as the thickness of the first resin 2 or film 4. In other words, the etching is performed so that the distance between the conductors 11 is identical to the thickness of the first resin 2 or film 4 and is varied depending on the thickness of the first resin 2 or film 4.

Further, the etching is performed as much as the thickness of the initial thin metal plate 1 so that the conductors 11 do not contact each other. Both end portions of the thin metal plate 1, which are positioned on both ends of the insulator 21, are preferably etched out so that the edges of the thin metal plate 1 are indented from the edges of the underneath insulator 21.

In a preferred embodiment, as an etching method, a laser 50 may be preferably used to remove the other portions than where the conductors 11 are to be formed, or a chemical etching process may also be used in which the other portions than where the conductors 11 are to be formed are removed, with where the conductors 11 are to be formed coated with photoresist.

Further, the etched intervals may be adjusted to adjust the pitch between the conductors 11. Upon etching using a laser, each conductor 11 may have various cross sections, such as rectangle, trapezoid, parallelogram, or triangle, depending on the angle at which a laser beam is incident. A plurality of lasers 50 may be used to etch quickly and in a broader range.

Of the method for manufacturing a semiconductor test pad with stacked metal sheets according to a first embodiment of the present invention, as shown in Fig. 5(a), the second primer applying step S53a is a step of increasing surface adhesivity by applying a primer 40 onto an upper surface of the second sheet where the conductors 11 are positioned and is a prior task for coating a second resin 3.

According to a preferred embodiment, the primer may be applied by any one of coating, paining, and spraying, and it is preferable to apply the primer to form a thickness of 1 µm to 2 µm.

The second primer applying step S3a is an ancillary task performed prior to coating a resin to produce the semiconductor test pad 5 with higher quality. The method or amount of application may vary depending on the material, temperature, and moisture. The second primer applying step S3a may be omitted.

Of the method for manufacturing a semiconductor test pad with stacked metal sheets according to a first embodiment of the present invention, as shown in Fig. 5(b), the coating step S3b is to apply a second resin 3 onto an upper surface of the second sheet or the second sheet applied with the primer 40 through the second primer applying step S3a, and in this step, the second resin 3 is coated onto the upper surface of the second sheet.

Further, the second resin 3 may include any one of silicone, urethane, PP, PE, PT, and rubber. A plurality of nozzles may be used to spray quickly and in a broader range.

Accordingly, as the second resin 3 is coated, a second resin layer is formed on the upper surface of the second sheet as shown in (B) or (C) of Fig. 5(b) and plays a role as an insulator like the first resin layer.

In a preferred embodiment, the second resin layer (hereinafter, an insulator) is preferably coated to have a thickness of 10 µm to 50 µm that is the same as the height of the conductors 11 (the thickness of the thin metal plate 1) as denoted in (B) to present higher quality, but as necessary, the second resin layer may be coated to a thickness larger than the height of the conductors 11 as denoted in (C) or to a thickness smaller than the height of the conductors 11 by adjusting the amount coated.

It is preferable to use the same resin as the first resin 2, but as necessary, a resin containing a different component(s) may be coated as well.

Further, as necessary, the coating step may be omitted as denoted in (A) of Fig. 5(b). In case the coating step is omitted, the insulator of another second sheet is stacked, in the subsequent stacking step S3, on the upper part of the second sheet having the conductors on its surface to cover the upper part of the second sheet, thus providing the same effect as if the coating step has been done.

Fig. 6 illustrates a stacking step using an adhesive of a method for manufacturing a semiconductor test pad with stacked metal sheets according to a second embodiment of the present invention. The stacking step includes forming an adhesive layer by applying an adhesive and stacking.

Specifically, in the stacking step S3, an adhesive is applied onto the upper surface of the conductors 11 positioned on one surface of the second sheet 61 as denoted in 401 to thus form an adhesive layer 6. Specifically, the adhesive layer 6 may be formed in the shape denoted in (A) or (B) of 402.

In a preferred embodiment, the adhesive 10 may be applied by any one of coating, painting, and spraying, and it is preferable that the adhesive 10 may be applied in the amount that presents the same thickness as the conductors 11 in the case of the shape denoted in (A) of 402 or in the amount that allows the adhesive layer to be thicker than the conductors 11 in the case of the shape denoted in (B) of 402.

Of the method for manufacturing a semiconductor test pad with stacked metal sheets according to the present invention, as shown in Fig. 7, the stacking step S3 is a step of forming a stack 62 by stacking a plurality of second sheets to a predetermined height one over the upper surface of another in parallel with one another.

In stacking the plurality of second sheets, an adhesive is applied onto the upper surface of each second sheet so that the second sheets may be fastened.

As the adhesive, one that, as cured, presents insulating properties should be selected, and for more insulation, the adhesive may further contain any one of silicone, urethane, PP, PE, PT, and rubber.

Further, any one of silicone, urethane, PP, PE, PT, and rubber may be applied in liquid phase for the purpose of an adhesive.

Further, the adhesive may be applied by any one of coating, painting, and spraying, and the adhesive is applied preferably in the amount that presents a thickness of 1 µm to 10 µm, but depending on the material, temperature, or moisture, the proper amount applied may vary without specially limited unless the amount applied is too small to present adhesion.

In a preferred embodiment, the second sheets are sequentially stacked in such a manner that an adhesive is applied onto the upper surface of one second sheet and another second sheet is stacked on the second sheet and then cured by heating and pressurizing, and is then stacked still another second sheet, and on and on.

In another embodiment, a stack 62, after prepared in a way that an adhesive is applied onto the upper surface of one second sheet, and another second sheet is stacked thereon, and still another second sheet is then stacked using an adhesive, and on and one, may be hardened by heating and pressurizing.

Further, heating and pressurizing is a curing method, and only one of heating and pressurizing may be performed. Or, curing may be done by natural drying.

The temperature for heating is preferably 50°C to 120°C, but without specially limited as long as it is a temperature that is not less than a room temperature and may accelerate curing and is not more than the melting point of the insulator used.

The pressure for pressurizing varies depending on the material of the insulator used, and the pressurizing is preferably performed so that the stack 62 has a variation ratio in its cross sectional width within 1% to 10%.

Accordingly, the second sheets are formed into a single stack 62 by the stacking method, and the stack 62 has a cross section shaped so that a plurality of conductors 11 are arranged at predetermined intervals in multiple rows and columns inside the rectangular shape of insulators 21.

Of the method for manufacturing a semiconductor test pad with stacked metal sheets according to the present invention, as shown in Fig. 8, the cutting step S4 is to vertically cut the stack 62 in a traverse direction at predetermined intervals into a plurality of semiconductor test pads 5.

Specifically, the stack 62 is vertically cut in a parallel with its surface where the conductors 11 are formed at predetermined intervals starting from the surface, and as a cutting method, a laser 50 or any one of other cutting tools, such as a wire or knife blade, may be used.

The vertical cutting may be performed sequentially from a side of the stack 62 at predetermined intervals, or may be simultaneously performed at multiple positions.

In a preferred embodiment, the cutting may be conducted at intervals that allow each semiconductor test pad 5 to be 1mm to 3mm thick, preferably. Considering the condition where the semiconductor test pads 5 are used, however, the cutting intervals may be adjusted under various conditions.

As shown in Fig. 9, after the cutting step S4, individual semiconductor test pads 5 with stacked metal sheets are manufactured, and the semiconductor test pads 5 may be subjected to an additional plating step S5 (not shown).

As manufactured by a method for manufacturing a semiconductor test pad with stacked metal sheets according to the first embodiment or second embodiment of the present invention, the semiconductor test pad includes first layers 21a, each of which includes an insulator rectangular in cross section and having a predetermined length along a Y-axis direction, and second layers 21b, each of which includes a plurality of rectangular conductors 11 passing, in a Z-axis direction and at predetermined intervals, through insulators each rectangular in cross section and having the same height along the Z-axis direction as the first layer 21a and the same length along the Y-axis direction, wherein the first layers 21a and the second layers 21b are alternately stacked along the X-axis direction, thus allowing the overall semiconductor test pad to look like a rectangular pad. First layers 21a are positioned at both end portions of the pad along the X-axis.

As described above, the semiconductor test pad 5 manufactured through the cutting step S4 has upper and lower portions of the same shape, and the side portions of the semiconductor test pad 5 are formed of insulators.

Further, as denoted in A1, there are formed first layers 21a each including an insulator rectangular in cross section and having a predetermined length along the Y-axis direction and second layers 21b formed on side surfaces of the first layers 21 a in the X-axis direction, each of the second layers 21b including insulators rectangular in cross section and having the same height as the Z-axis height of the first layers 21a and a plurality of conductors 11 having the same Z-axis height and evenly spaced apart from each other along the Y-axis direction and passing through the insulators in the Z-axis direction.

The second layers 21b and the first layers 21a are alternately stacked to be positioned on the sides of the first layers 21a in the X-axis direction, and first layers 21a are formed at both end portions of the pad along the X-axis.

As described above, the plurality of first layers 21a and the plurality of second layers 21b are alternately stacked, forming a rectangular semiconductor test pad 5.

No conductors 11 are formed at both end portions in the Y-axis direction of the second layers 21b, and the side portions of the second layers 21b remain configured with insulators.

As the first layers 21a and the second layers 21b are fusion-bonded through the stacking step S3, such as heating and pressurizing, of the manufacturing process, the semiconductor test pad 5 may look like a single insulator.

Further, the conductors 11 formed in the second layer 21b may be shaped as if they are pushed toward the first layer 21a as denoted in B3, and this is formed by the coating method of the coating step S3b of the process of preparing the semiconductor test pad 5 so that the insulator is coated to be higher than the conductors 11.

Further, if the B3's are stacked to form a single sheet shape as denoted in B2, the intervals between the conductors 11 in the X-axis direction become larger than in the A2 due to the difference in height H2 of the insulator 21 although the thickness H1 of the conductors 11 remains the same.

In a preferred embodiment, it is preferable that the interval between the conductors is 10 µm to 50 µm and the thickness H1 of each conductor is 5 µm to 30 µm, but they may be varied depending on the thickness of the resin coated and the thickness of the thin metal plate. The upper surface of the conductors formed upon etching may be partially etched to allow the conductors to be thinner.

The plating step S5 that may be performed after the cutting step S4 is to plate the upper and lower surfaces of each conductor 11 to prevent corrosion of the conductors 11 exposed through the upper and lower surfaces of the semiconductor test pad 5, and the semiconductor test pad 5 that has undergone the plating step S5 further includes plating layers on its upper and lower surfaces.

In the plating step S5, the overall outer surface of each semiconductor test pad is plated. However, the plating material is not attached to the insulators 21 except the conductors 11, and thus, the insulators 21 are not plated.

Accordingly, only the upper and lower surfaces of each conductor 11, which are exposed to the outside, are plated.

In a preferred embodiment, the plating is preferably performed by an electroless plating method in which metal ions in the metal salt aqueous solution are auto-catalytically reduced by the force of a reducing agent without fed with electric energy to thus deposit metal on the surface of an object to be processed, and first plating and second plating may be separately performed for higher plating quality.

Further, the first plating may differ in plating material from the second plating. The metals used for plating are determined by making comparisons on the reactivity of the conductors 11 (tendency for metal atoms to be oxidized to cations). The conductors 11 are most reactive, the metal used for the first plating is less reactive than the conductors 11, and the metal used for the second plating is less reactive than the metal for the first plating.

Accordingly, after plated depending on the reactivity of the metals, the conductors 11 may be prevented from surface-corrosion.

For example, the conductors 11 are formed of Cu, and in case only the first plating is performed, the plating is performed using a metal with lower reactivity than Cu, such as Au or Ag.

In case the conductors 11 are formed of Cu and the first and second plating both are performed, the first plating is performed using a metal with lower reactivity than Cu, such as Ni or Ag, followed by the second plating using a metal with lower reactivity than the metal used for the first plating, such as Pt or Au.

In a preferred embodiment, in case only the first plating is performed, the thickness of the plating is preferably 1 µm to 10 µm, and in case both the first plating and the second plating are performed, the total thickness of the plating is preferably 1 µm to 15 µm.

Although the present invention has been described in connection with preferred embodiments thereof with reference to the accompanying drawings, it is apparent to one of ordinary skill in the art that various changes may be made thereto without departing from the scope of the present invention. Accordingly, the scope of the present invention should be interpreted by the following claims described to include such various changes.

## Claims

1. A method for manufacturing a semiconductor test pad with stacked metal sheets, the method comprising: a sheet preparing step S1 of preparing a first sheet by coating a conductive metal plate 1 with an insulating first resin 2; an etching step S2 of preparing a second sheet by etching the first sheet of the metal plate 1 to have a plurality of lines so that conductors 11 respectively on the lines are spaced apart from each other at a predetermined distance; a stacking step S3 of preparing a stack 62 by stacking a plurality of second sheets; and a cutting step S4 of vertically cutting the stack 62 to a predetermined thickness.

2. The method of claim 1, wherein the first resin 2 includes at least any one of silicone, urethane, PE, PP, PT, and rubber.

3. The method of claim 1, further comprising, after the etching step, a coating step of coating a second resin 3 on an upper portion of the second sheet formed with the conductors 11 on the lines so that the second resin 3 is formed as an insulator.

4. The method of claim 2, wherein the second resin 3 includes at least any one of silicone, urethane, PE, PP, PT, and rubber.

5. The method of claim 1 or 3, wherein, before coating the first resin 2 or the second resin 3, a primer 40 is applied on a surface where to be coated to increase the adhesivity of a resin to be coated.

6. A method for manufacturing a semiconductor test pad with stacked metal sheets, the method comprising: a sheet preparing step S1 of preparing a first sheet by attaching a conductive metal plate onto a surface of an insulating film; an etching step S2 of preparing a second sheet by etching the first sheet of the metal plate to have a plurality of lines so that conductors respectively on the lines are spaced apart from each other at a predetermined distance; a stacking step S3 of preparing a stack by stacking a plurality of second sheets; and a cutting step S4 of vertically cutting the stack 62 to a predetermined thickness.

7. The method of claim 6, wherein the film includes at least any one of silicone, urethane, PI, PET, PEN, PE, PP, PT, and rubber.

8. The method of claim 6, wherein in the stacking step, an adhesive is applied onto an upper portion of the second sheet where the conductors on the lines are formed, and the plurality of second sheets are stacked using an adhesive layer formed of the adhesive.

9. The method of claim 8, wherein the adhesive layer includes at least any one of silicone, urethane, PI, PET, PEN, PE, PP, PT, and rubber.

10. The method of claim 1 or 6, further comprising, after the cutting step, a plating step of performing electroless plating on a surface of the semiconductor test pad to prevent the conductors 11 from being oxidized.

11. The method of claim 1 or 6, wherein the thin metal plate 1 includes at least any one of Cu, Au, Ag, Pt, Fe, Al, Ni, Mg, Pb, Zn, Sn, Co, Cr, Mn, and C.

12. A semiconductor test pad with stacked metal sheets, comprising: s first layers 21a, each of which includes an insulator rectangular in cross section and having a predetermined length along a Y-axis direction, and second layers 21b, each of which includes a plurality of rectangular conductors 11 passing, in a Z-axis direction and at predetermined intervals, through insulators each rectangular in cross section and having the same height along the Z-axis direction as the first layer 21a and the same length along the Y-axis direction, wherein the first layers 21a and the second layers 21b are alternately stacked along the X-axis direction, thus allowing the semiconductor test pad to overall look like a rectangular pad, and wherein first layers 21 a are positioned at both end portions along the X-axis.

13. The semiconductor test pad of claim 12, further comprising a plating layer on each of an upper surface and a lower surface of the conductors 11.
